# EUROPEAN PATENT APPLICATION

(11) **EP 4 578 969 A1**
(43) Date of publication of application: **02.07.2025**
(21) Application number: 23857439.6
(22) Date of filing: 25.08.2023
(51) Int. Cl.: C22C 1/10, B22D 19/00, B22F 1/00, B22F 1/12, B22F 3/26, C04B 35/528, C22C 1/04, C22C 1/05, C22C 32/00

(54) **METAL AND/OR CERAMIC/GRAPHITE-CONTAINING ALUMINUM COMPOSITE MATERIAL AND METHOD FOR PRODUCING METAL AND/OR CERAMIC/GRAPHITE-CONTAINING ALUMINUM COMPOSITE MATERIAL**

(30) Priority: 26.08.2022 JP 2022135173; 11.05.2023 JP 2023078800
(71) Applicant: Advanced Composite Corporation, Fuji-shi, Shizuoka 417-0801 (JP)
(72) Inventor: HAYASHI Mutsuo, Fuji-shi, Shizuoka 417-0801 (JP); HATTORI Junichi, Fuji-shi, Shizuoka 417-0801 (JP)
(74) Representative: Wächtershäuser & Hartz Patentanwaltspartnerschaft mbB
(86) International application number: PCT/JP2023/030698
(87) International publication number: WO 2024/043331

(57) **Abstract**

The present invention intends to realize a metal and/or ceramic/graphite-containing aluminum composite that is obtained by forming a composite using a carbon/graphite-based material and an aluminum material, that has a high strength, a high thermal conductivity, and a low coefficient of thermal expansion, and that can be industrially utilized in a wide range. The present invention also intends to develop a technique of providing the material. There is provided a metal and/or ceramic/graphite-containing aluminum composite obtained by forming a composite from a molded body and a molten aluminum metal or a molten aluminum alloy, wherein the molded body is formed of a material obtained by externally adding a silica-based binder to a mixed powder containing a powder of graphite which is not amorphous and a metal powder and/or ceramic powder, the metal and/or ceramic/graphite-containing aluminum composite has a flexural strength of 90 MPa or higher, a thermal conductivity of 240 W/m·K or higher in either the XY direction or the Z direction, and a coefficient of thermal expansion of 6.0 ppm/K or lower in either the XY direction or the Z direction. There is also provided a method for producing the composite.

## Description

### Technical Field

The present invention relates to a metal and/or ceramic/graphite-containing aluminum composite and a method for producing a metal and/or ceramic/graphite-containing aluminum composite. In more detail, the present invention relates to a technique of providing a metal and/or ceramic/graphite-containing aluminum composite that exhibits a high strength, a high thermal conductivity, and a low coefficient of thermal expansion.

### Background Art

Carbonaceous and graphite-based materials are used in many fields as excellent industrial materials because they are light in weight; they exhibit excellent functionalities, such as high thermal conductivity, high electrical conductivity, high heat resistance, and high chemical resistance; they can be easily processed; and they are inexpensive, mass-produced, and readily available. Recently, research and development have been conducted on composites obtained by imparting properties of metals or other materials to carbon-based or graphite-based materials, such as composites obtained by impregnating graphite with an aluminum alloy, CRFPs (carbon fiber reinforced plastics) obtained by forming a composite from a carbon fiber and a plastic, and CMCs obtained by forming a composite from carbon and a ceramic, and these composites have been put into practical use.

Graphite materials other than carbon fibers are produced by, for example, molding and sintering a powder, such as coke, but have not been used as structural materials for mechanical members due to their low strength. In addition, although such graphite materials other than carbon fibers are materials having a high thermal conductivity, their use as a heat dissipation part has been limited because of its low thermal conductivity compared to that of copper or aluminum. Therefore, there is a long-awaited need to improve the properties of graphite materials and enable their applications in structural members and heat dissipation members. Techniques that can utilize graphite as heat dissipation members include the followings for example.

For example, power modules for electrical control which are used in recent electric vehicles, highspeed trains, and the like have a structure in which a silicon semiconductor device is bonded to a substrate, which is an insulator made of a resin or a ceramic, and a heat dissipation material of a copper plate or graphite, which has excellent thermal conductivity and heat dissipation properties, is bonded to the bottom of the substrate to dissipate heat generated from the silicon semiconductor. The structure is designed to dissipate the heat emitted from the silicon semiconductor. However, when there is a difference in the coefficient of thermal expansion among the silicon semiconductor, the insulator (substrate), and the heat dissipation member, or when the strength of the heat dissipation material is low, stress due to the difference in the coefficient of thermal expansion may occur at the bonding surface between the insulator (substrate) and the heat dissipation plate, which may cause a crack or breakage. Specifically, when the heat dissipation plate is made of copper, the difference in the coefficient of thermal expansion is large, and therefore there is a problem that a crack occurs. When the heat dissipation plate is made of graphite, there is a problem that breakage or a crack occurs due to the lack of strength of graphite.

In recent years, semiconductors using SiC single crystals, gallium nitride single crystals, or the like, which have a further larger electrical band gap, have come to be used as semiconductors for power modules, replacing conventional silicon semiconductors made from silicon wafers. However, while conventional silicon semiconductors, when used, generate heat of around 100°C, the operating temperature of SiC semiconductors and gallium nitride semiconductors, when used, are known to reach a higher temperature of around 200°C. Therefore, when it is made possible to provide a material having a coefficient of thermal expansion that is closer to the coefficient of thermal expansion of semiconductor materials such as SiC or gallium nitride, as a material of a substrate or heat dissipation plate to be installed under the SiC semiconductors or gallium nitride semiconductors, it enables providing more excellent power modules.

Specifically, as materials for substrates and heat dissipation plates installed under the semiconductors, it is desirable to provide materials that, in addition to having sufficient strength and thermal conductivity, exhibit a low coefficient of thermal expansion, specifically have a coefficient of thermal expansion close to, for example, 4 to 6 ppm/K, which is the coefficient of thermal expansion of SiC, gallium nitride, or the like, which are the materials of the above-described semiconductors, and also have a high strength and a high thermal conductivity. On the other hand, there is no known general-purpose, economical material that satisfies all of the required performances as described above on its own, and therefore it is desirable to develop a composite. Here, when composites are applied as substrates or heat dissipation plate to be installed under the semiconductors, the coefficient of thermal expansion in either the XY direction or the Z direction may be close to the coefficient of thermal expansion of the semiconductors. In other words, in the case where a substrate or heat dissipation plate made of a composite is used, for example, the use of a composite having a coefficient of thermal expansion in the XY direction closer to the coefficient of thermal expansion of a semiconductor and bonding the composite to the semiconductor in the XY direction make it possible to allow the composite to fully exhibit the functions thereof.

As described above, the development of a material that exhibits a high strength, a low coefficient of thermal expansion, and a high thermal conductivity is long awaited as a practical composite that is applicable to materials of substrates and heat dissipation plates to be installed under the semiconductors such as SiC and gallium nitride. Specifically, it would be extremely useful if a new material is provided that meets all of the following requirements: having a flexural strength of 90 Mpa or higher, which is a practical flexural strength; having a coefficient of thermal expansion of 6 ppm/K or lower in either the XY direction or the Z direction; and having a thermal conductivity of 240 W/m·K or higher in either the XY direction or the Z direction.

Under such circumstances, development of composites of graphite-based materials and aluminum metal is underway, and as one of the methods, disclosed are methods of impregnating pores of a molded body made of carbon (carbonaceous material) or a graphite-based material (hereinafter also referred to as carbon/graphite-based material) with an aluminum alloy, and some of them have been put into practical use. For example, Patent Literature 1 discloses a carbon matrix metal composite in which 90% by volume or more of the pores of the graphite crystal-containing carbonaceous matrix are replaced by a metallic component, such as aluminum or magnesium. In addition, Patent Literature 1 also discloses a production method wherein a carbon molded body whose porosity is less than 40% by volume is pressure-impregnated with a molten metal. It is stated that according to the technique disclosed in Patent Literature 1, a composite having a thermal conductivity of 150 W/m·K or higher can be obtained.

Patent Literature 2 discloses a carbon matrix metal composite obtained by pressure-impregnating, a carbon molded body containing graphitized carbon particles and having a porosity of 35% or less with an aluminum metal or an aluminum alloy by squeeze casting. It is stated that this composite is useful as electronic device substrates having a high thermal conductivity, a low coefficient of thermal expansion, and a low elastic modulus. Patent Literature 3 discloses an electrode material for electrodischarge machining wherein a graphite material is impregnated with an Al alloy containing 10% or more of a Si component by a squeeze casting method or an HIP method. Patent Literature 4 discloses a metal-graphite composite having a high thermal conductivity in the biaxial direction, which is suitable for two-dimensional diffusion of heat.

Patent Literature 5 discloses a technique as follows: a coke powder or a mixed powder of a coke powder and a graphite powder is mixed with a powder of a carbide such as titanium carbide, or a powder of an oxide such as titanium oxide, or a powder of metallic titanium or the like, and tar or pitch is added to the resulting mixed powder to make the mixed powder into a paste form; the paste is subjected to extrusion molding and then primary firing at 1000 to 1500°C to obtain a solid; the obtained solid is impregnated with tar or pitch under pressure and is then subjected to primary firing at 1000 to 1500°C, and this primary firing is repeated a plurality of times; thereafter final firing is performed in which firing is performed at 2500 to 3000°C to obtain an extrusion-molded body; and the obtained extrusion-molded body is pressure-impregnated with aluminum to make an aluminum-graphite-carbide composite. It is stated that according to the above-described technique, the composite has improved brittleness and still has a suitable thermal conductivity.

Patent Literature 6 discloses: a sheet-like aluminum-silicon carbide composite obtained by pressure-impregnating a molded body with aluminum or an aluminum alloy at a high pressure, wherein the molded body is obtained by adding a silicon carbide powder to a "synthetic graphite powder obtained by graphitizing coke-based carbon" and press-molding the resulting mixture; and a method for producing the composite. It is stated that by this technique, a composite having properties of a low thermal expansion and a high thermal conductivity is provided. Patent Literature 7 states that when a molded body is pressure-impregnated with aluminum or an aluminum alloy at a high pressure, wherein the molded body is obtained by adding a silicon carbide powder and a boron nitride powder to a "synthetic graphite powder obtained by graphitizing coke-based carbon" and press-molding the resultant mixture, thereby a sheet-like aluminum-silicon carbide complex can be made so as to exhibit good processability in addition the above-described effect. In these literatures, synthetic graphite powders each having an average particle size of 1 to 1,000 µm are used.

Patent Literature 8 discloses: an aluminum-graphite-silicon carbide complex obtained by pressure-impregnating a molded body containing a graphite powder and a silicon carbide powder with aluminum or an aluminum alloy by a squeeze casting method; and a method for producing the complex. Patent Literature 8 discloses: using a "synthetic graphite powder obtained by graphitizing coke-based carbon" as a graphite powder as in Patent Literature 6 and Patent Literature 7; and, on top of that, using a "scale-like graphite powder" as part or the whole of the synthetic graphite powder. The "synthetic graphite powder obtained by graphitizing coke-based carbon" is an amorphous graphite powder, and the "scale-like graphite powder" is a graphite powder having a crystal structure.

Patent Literature 9 discloses a heterogeneous composite having an integrated structure, the composite obtained by impregnation and casting of two adjacent preformed bodies each formed of a different type of reinforcing material with a molten metal of aluminum or the like under a high pressure. Specifically, Patent Literature 9 discloses a heterogeneous composite having an integrated structure, the composite obtained by impregnation and casting of adjacent preformed body formed of silicon carbide particles and preformed body formed of graphite or adjacent preformed body formed of alumina particles and preformed body formed of carbon fiber with a molten metal to be a matrix under a high pressure. Patent Literature 9 states that when a reinforcing material is a ceramic, even a molded body in which an inorganic binder, such as silica sol and alumina sol, is added to the ceramic can also be utilized.

### Citation List

### Patent Literature

Patent Literature 1: Japanese Patent No. 3673436
Patent Literature 2: Japanese Patent No. 3351778
Patent Literature 3: Japanese Patent Laid-Open No. 2004-209610
Patent Literature 4: Japanese Patent No. 4441768
Patent Literature 5: Japanese Patent No. 6722089
Patent Literature 6: Japanese Patent No. 5208616
Patent Literature 7: Japanese Patent No. 5368766
Patent Literature 8: Japanese Patent No. 5061018
Patent Literature 9: Japanese Patent No. 4384830

### Summary of Invention

### Technical Problem

As described above, various composites of carbon/graphite-based materials and an aluminum metal have been disclosed so far, and a composite that has achieved a high thermal conductivity of 150 W/m·K or higher has been obtained (see Patent Literature 1). However, as described in the conventional techniques (see Patent Literature 5 and the like) above, there is a need to provide a composite of a carbon/graphite-based material and an aluminum metal that improves brittleness of the composite, in other words, that has a high strength, and that achieves a high and suitable thermal conductivity, and therefore various studies have been conducted, but it is still difficult to say that the above-described points have been solved. For example, in the conventional technique described in Patent Literature 5 that utilizes a coke powder and tar or pitch, which purports to have solved the above-described points, an extrusion-molded body which is an intermediate body needs to be obtained by repeating complicated primary firing at 1,000 to 1,500°C plurality of times and then further performing final firing in which firing is performed at 2,500 to 3,000°C. As just described above, the conventional technique requires a high firing temperature in addition to complicated production steps, which increases production costs and makes it difficult to put the conventional technique into practical use, and therefore the conventional technique cannot be utilized in a wide range.

As the types of the graphite powders which are used as the materials for forming composites with aluminum and the like in the conventional techniques, a graphite powder that is amorphous and a graphite powder having a crystal structure, such as a natural graphite powder are used, and there are differences between them as described below. For example, when a scale-like graphite powder having a crystal structure, like the one studied in Patent Literature 8, is used as a graphite powder, it is stated that an aluminum-graphite-silicon carbide composite whose thermal conductivity in the direction perpendicular to the molding direction is remarkably increased is obtained. As described in Tables of Patent Literature 8, in the cases of composites each using an amorphous graphite powder such as the "synthetic graphite powder obtained by graphitizing coke-based carbon," a high thermal conductivity that has been achieved in the composite using a scale-like graphite powder has not been obtained. On the other hand, in the cases of composites each using a scale-like graphite powder, a high strength that has been achieved in the cases of the composites each using an amorphous graphite powder has not been able to be obtained.

Further, when a graphite powder is used as a material for forming a composite, there is a problem that a molded body (preform) which is used when a composite is formed by impregnation with a molten aluminum metal or the like is inferior in shape stability in addition to moldability. According to studies conducted by the present inventors, when a graphite powder is used as a material for forming a composite, springback, in which the density of the molded body returns to its original level, is likely to occur in the step after a molded body is obtained by press-molding using the material for forming a composite, and therefore a complicated step for suppressing the occurrence of the springback is necessary. For this reason, there is a serious industrial challenge that no practical production method has yet been developed. For example, in Examples of Patent Literatures 6 to 8 as conventional techniques, a material in which a graphite powder is used is filled in a steel container to prepare a molded body by press-molding, and in order to suppress the springback, the upper and lower steel plates of the steel container are welded to cover the steel container to hold the obtained molded body in the steel container, and in this state, a composite is formed by impregnating the molded body with a molten aluminum alloy at a high pressure.

Furthermore, as described above, as a practical composite applicable to materials for substrates and heat dissipation plates to be installed under the semiconductors such as SiC and gallium nitride, which have been used in recent years, the development of a material that satisfies all the following requirements of having a high strength, a low coefficient of thermal expansion, and a high thermal conductivity, is long awaited, wherein the requirements are as follows: having a flexural strength of 90 Mpa or higher, which is a practical flexural strength; having a coefficient of thermal expansion of 6 ppm/K or lower in either the XY direction or the Z direction; and having a thermal conductivity of 240 W/m.K or higher in either the XY direction or the Z direction. Under such circumstances, such an excellent material has never been provided by conventional techniques.

Recently, high-tech carbons such as graphene, fullerene, and carbon nanotubes have been attracting attention, and their potential physical properties such as high thermal conductivity have been attracting attention. However, these materials are very fine powders and therefore difficult to handle, and their utilization methods have not yet been established. Generally, when a fine graphite powder is utilized to obtain a composite, the composite is produced in such a way that: a binder such as tar or pitch is added to the fine graphite powder; the resulting mixture is subjected to extrusion molding and CIP molding and then fired at about 3,000°C to obtain a graphite block with 5 to 35% of voids; and the graphite block is impregnated with molten aluminum. However, it is considered to be actually difficult to impregnate all the voids with a metal by this method because part of these voids become closed pores due to a binder or the like. Therefore, composites utilizing conventional carbon/graphite-based materials have a low strength because the inherent strength of graphite is low and the impregnation amount of a metal such as aluminum or an aluminum alloy, or copper is low in the composition of the composite, so that the range of use of such composites has been limited.

Accordingly, the present invention intends to: provide an industrially and widely utilizable and extremely useful metal and/or ceramic/graphite-containing aluminum composite that is obtained by forming a composite from a mixed powder of a crystalline carbon/graphite-based material and a metal powder material other than aluminum and/or a ceramic powder material with a molten aluminum metal or a molten aluminum alloy and that has a high strength, a high thermal conductivity, and a low coefficient of thermal expansion, which are described above; and furthermore develop a technique that makes it possible to simply and stably provide this metal and/or ceramic/graphite-containing aluminum composite without a need for a complicated step.

### Solution to Problem

The above-described objects are achieved by the present invention described below. Specifically, the present invention provides a metal and/or ceramic/graphite-containing aluminum composite described below.
[1] A metal and/or ceramic/graphite-containing aluminum composite obtained by forming a composite from a molded body having voids and a molten aluminum metal or a molten aluminum alloy, wherein
   the molded body having voids is formed of a mixed powder composed of: a graphite powder composed of a natural graphite powder or a synthetic graphite powder each having a crystal structure that is not amorphous; and a metal powder and/or a ceramic powder,
   a silica-based inorganic binder is further added to the mixed powder,
   the metal and/or ceramic/graphite-containing aluminum composite contains the graphite powder within a range of 40 to 80% by volume, the aluminum metal or the aluminum alloy within a range of 13 to 50% by volume, the metal powder and/or the ceramic powder within a range of 6 to 45% by volume in total, provided that the total amount of those materials is 100% by volume, and the silica-based inorganic binder is externally added in an amount of 0.5 to 5% by volume in terms of SiO₂, and
   the metal and/or ceramic/graphite-containing aluminum composite has a flexural strength of 90 MPa or higher, a thermal conductivity of 240 W/m·K or higher in either the XY direction or the Z direction, and a coefficient of thermal expansion of 6.0 ppm/K or lower in either the XY direction or the Z direction.
   Preferred embodiments of the metal and/or ceramic/graphite-containing aluminum composite include the following.
[2] The metal and/or ceramic/graphite-containing aluminum composite according to [1], wherein the thermal conductivity in the XY direction is 240 W/m·K or higher, the thermal conductivity in the Z direction is 50 W/m·K or higher, the coefficient of thermal expansion in the XY direction is 6 ppm/K or lower, and the coefficient of thermal expansion in the Z direction is 19 ppm/K or lower.
[3] The metal and/or ceramic/graphite-containing aluminum composite according to [1] or [2], wherein the coefficient of thermal expansion in the XY direction is 3 ppm/K or higher and 6 ppm/K or lower.
[4] The metal and/or ceramic/graphite-containing aluminum composite according to any one of [1] to [3], wherein the silica-based inorganic binder contains at least any one selected from the group consisting of colloidal silica, ethyl silicate, water glass, and silicone resins.
[5] The metal and/or ceramic/graphite-containing aluminum composite according to any one of [1] to [4], wherein the graphite powder has an average particle size of 3 µm to 300 µm.
[6] The metal and/or ceramic/graphite-containing aluminum composite according to any one of [1] to [5], wherein the crystal structure that is not amorphous is any one of crystal structures selected from the group consisting of a layered crystal, a three-dimensional graphite crystal, a diamond crystal, and a fullerene structure.
[7] The metal and/or ceramic/graphite-containing aluminum composite according to any one of [1] to [6], wherein the metal powder and/or the ceramic powder has an average particle size of 0.5 to 200 µm.
[8] The metal and/or ceramic/graphite-containing aluminum composite according to any one of [1] to [7], wherein the metal powder is any one selected from the group consisting of a silicon powder, a titanium powder, a silver powder, a copper powder, an iron powder, a stainless steel powder, and an aluminum powder, and the ceramic powder is any one selected from the group consisting of an alumina powder, a silicon nitride powder, a silicon carbide powder, and aluminum nitride powder.
   The present invention provides a method of producing a metal and/or ceramic/graphite-containing aluminum composite, described below, as another embodiment.
[9] A method for producing a metal and/or ceramic/graphite-containing aluminum composite, the method including:
   a molding step of forming a molded body by adding a silica-based inorganic binder within a range of 0.5 to 5 parts by volume in terms of SiO₂ to 100 parts by volume of a mixed powder of raw materials prepared in such a way that the total of 40 to 80% by volume of a graphite powder composed of a natural graphite powder or a synthetic graphite powder each having a crystal structure that is not amorphous, 6 to 45% by volume in total of a metal powder and/or a ceramic powder, and 13 to 50% by volume of voids in the molded body after molding is 100% by volume, forming a molded material with the resulting material, and solidifying the molded material by heating at a temperature of 100°C to 1,100°C to prepare the molded body having voids to be used for composite formation; and
   a composite forming step of impregnating the voids of the molded body with a molten aluminum metal or a molten aluminum alloy at a pressure of 20 to 200 MPa or injecting a molten aluminum metal or a molten aluminum alloy into the voids of the molded body at a pressure of 20 to 200 MPa, thereby forming a composite, wherein
   a composite having a flexural strength of 90 MPa or higher, a thermal conductivity of 240 W/m·K or higher in either the XY direction or the Z direction, a coefficient of thermal expansion of 6.0 ppm/K or lower in ether of the XY direction or the Z direction is produced.
   Preferred embodiments of the method for producing a metal and/or ceramic/graphite-containing aluminum composite of the present invention include the following.
[10] The method for producing a metal and/or ceramic/graphite-containing aluminum composite according to [9], wherein the silica-based inorganic binder contains at least any one selected from the group consisting of colloidal silica, ethyl silicate, water glass, and silicone resins.
[11] The method for producing a metal and/or ceramic/graphite-containing aluminum composite according to [9] or [10], wherein the method to be performed in the molding step of forming a molded body is at least any one selected from the group consisting of press molding, pressure filter press, rolling roll molding, CIP molding, a sedimentation method, and cast molding.

### Advantageous Effects of Invention

According to the present invention, there is provided an industrially and widely utilizable and extremely useful metal and/or ceramic/graphite-containing aluminum composite that is obtained by forming a composite from: a mixed material of powder of a metal and/or a ceramic and a carbon/graphite-based powder having a crystal structure; and an aluminum material composed of an aluminum metal or an aluminum alloy (hereinafter, also referred to as "aluminum metal or the like"), which is a metallic material, the metal and/or ceramic/graphite-containing aluminum composite having a high strength, a high thermal conductivity, and a low coefficient of thermal expansion. According to the present invention, the metal and/or ceramic/graphite-containing aluminum composite (hereinafter, also simply referred to as "graphite-based composite") having excellent properties can be produced stably by a simple method without a need for firing repeated at a high temperature as in conventional techniques and without a need for operation for retaining the form of a molded body, which therefore makes it possible to utilize the graphite-based composite having excellent properties as described above in a wide range.

An object of the present invention is to provide the graphite-based composite having excellent properties such as a high strength, a high thermal conductivity, and a low coefficient of thermal expansion, and the present inventors have found that the object can be realized by producing the graphite-based composite in the manner as described below. First, a molded body (preform) is impregnated with a molten aluminum metal or the like, or a molten aluminum metal or the like is injected into a molded body (preform) to form a composite, wherein the molded body (preform) is formed of a material obtained by adding a ceramic powder whose representative examples include a silicon carbide powder and an alumina powder and/or metal powder, such as a silicon powder and a titanium powder, to a natural graphite powder or a synthetic graphite powder, which exhibit a high thermal conductivity as a single substance and which has a crystal structure, and further adding a silica-based inorganic binder whose representative examples include colloidal silica and ethyl silicate to the resultant mixture, and thus the intended graphite-based composite having excellent properties can be prepared by a simple method.

The technical feature of the present invention is in that preparation of a molded body in the case where a carbon/graphite-based material is used, which has been difficult to solve even by a pressure-applying molding method whose representative examples include press molding has been solved by adding a silica-based inorganic binder to a mixed powder of raw materials to be used in the preparation of the molded body, thereby realizing: preparation of a molded body (preform) that is in a good condition; and furthermore, good formation of a composite from the molded body and the aluminum metal or the like. For example, according to the present invention, by allowing a silica-based inorganic binder to be contained in the raw materials for preparing the molded body, the strength of the molded material formed at room temperature by a method of press molding or the like can be increased, and therefore a strong molded body with suppressed springback that occurs thereafter can be obtained. By adding a silica-based inorganic binder to a mixed powder of raw materials to be used in the preparation of the molded body, the following effects can be achieved. Firstly, not only suppression of deformation of the molded body caused by impregnation of the molded body with a molten aluminum metal or the like at about 700°C and injection of the aluminum metal or the like is realized, but also adhesion between the graphite-based material having a crystal structure and the added metal and/or ceramic powder material is retained strongly inside the molded body. Secondary, in such a state, the composite can be formed by impregnating the molded body with the aluminum metal or the like and injecting the aluminum metal or the like into the molded body, which thereby makes it possible to provide the graphite-based composite that is an object of the present invention and that satisfies all the properties of a high strength, a high thermal conductivity, and a low coefficient of thermal expansion.

### Description of Embodiments

Hereinafter, the present invention will be described in detail giving preferred embodiments. As described above, there have been disclosed various methods for impregnating a carbon/graphite-based material or a ceramic-based material with a molten metal material, a molten aluminum material in particular, at a high pressure in conventional techniques. However, it is still hard to say that these techniques are complete, and the following problem has been pointed out.

Conventional composites obtained by impregnating a carbon/graphite-based material with a molten metal such as a molten aluminum metal or the like have a low strength, a low flexural strength in particular as low as a flexural strength of 15 to 30 MPa, and therefore there is a problem that such conventional composites, when made into mechanical parts that require strength or functional parts that require thermal conductivity, such as a heatsink and a heat dissipation plate, make the strength of the products insufficient. According to studies conducted by the present inventors, the reason for this is due to the following. The reason is considered to be due to the fact that, in addition to the fact that the strength of the carbon/graphite-based material to be used for a material for preparation of a composite is inherently low, even if these materials are impregnated with the molten aluminum metal or the like or a molten copper metal to form a composite, the impregnation amount of the aluminum metal or the like or the copper metal is low, as low as, for example, around 20% of the whole voids. In other words, the reason is due to the fact as follows: as described above, in a molded body prepared by forming a molded material with a material in which a binder such as tar or pitch that generates carbon is used as a carbon/graphite-based material and then firing the molded material, closed pores are likely to occur, so that when the molded body is impregnated with a molten metal, the closed pores are not impregnated satisfactorily with the metal, therefore the impregnation amount decreases as described above, and thereby an increase in the strength by impregnation with the metal is not obtained sufficiently.

Under such circumstances, disclosed is an aluminum-ceramic composite having excellent properties, the composite obtained by impregnating a molded body with an aluminum alloy, wherein the molded body is formed of a material obtained by mixing a silicon carbide powder, and, if necessary, a boron nitride powder with an amorphous synthetic graphite powder obtained by artificially graphitizing coke-based carbon (see Patent Literatures 6 to 8), as described above. However, in the conventional techniques, a single material or a composite is not known that is suitable for power module bases in recent years or heat dissipation plates, that has a flexural strength of 90 MPa or higher, which is a practical flexural strength, that has a higher strength and a higher thermal conductivity, and on top of those, that exhibits a low coefficient of thermal expansion in particular, specifically a coefficient of thermal expansion of 6 ppm/K or lower.

The present inventors have conducted diligent studies in order to solve the above-described problems of the conventional techniques to find a metal and/or ceramic/graphite-containing aluminum composite (graphite-based composite) of the present invention. Specifically, the present inventors have found the following production method to complete the present invention. That is, the production method can provide a graphite-based composite having "easy moldability," which is an important property for putting the graphite-based composite into practical use, and having a high strength, a high thermal conductivity, and a low coefficient of thermal expansion, which are at high levels and the objects of the present invention, and the production method can also produce the composite simply at low costs. The production method has been realized by utilizing a graphite powder that is not amorphous and has high crystallinity and a metal powder and/or a ceramic powder to enhance the strength in a composite of a carbon/graphite-based powder material and an aluminum metal or the like.

The graphite-based composite of the present invention is obtained by forming a composite from a molded body having voids and a molten aluminum metal or the like, wherein the molded body having voids is formed of a mixed powder composed of: a graphite powder having a crystal structure that is not amorphous; and a metal powder and/or a ceramic powder, and a silica-based inorganic binder is further added to mixed powder. The molded body that characterizes the present invention is formed of a material obtained by adding a silica-based inorganic binder within a range of 0.5 to 5 parts by volume to 100 parts by volume (including the voids) of the mixed powder. The graphite-based composite of the present invention has a material composition wherein the graphite powder is contained within a range of 40 to 80% by volume, the aluminum metal or the like is contained within a range of 13 to 50% by volume, the metal powder and/or the ceramic powder is contained within a range of 6 to 45% by volume, provided that the total amount of these materials is 100% by volume, and further the silica-based inorganic binder is externally added in an amount of 0.5 to 5% by volume in terms of SiO₂. The graphite-based composite of the present invention, composed of the above-described material composition, is characterized in that it exhibits excellent properties of a flexural strength of 90 MPa or higher, a thermal conductivity of 240 W/m·K or higher in either the XY direction or the Z direction, and a coefficient of thermal expansion of 6.0 ppm
/K or lower in either the XY direction or the Z direction.

Examples of the graphite-based composite of the present invention having preferred properties include graphite-based composites having a flexural strength of 90 MPa or higher, a thermal conductivity of 240 W/m·K or higher in the XY direction, a thermal conductivity of 50 W/m·K or higher in the Z direction, and a coefficient of thermal expansion of 6 ppm/K or lower in the XY direction, and a coefficient of thermal expansion of 19 ppm/K or lower in the Z direction. Among them, the graphite-based composite is more preferably one having a coefficient of thermal expansion of 3 ppm/K or higher and 6 ppm or lower in the XY direction.

Hereinafter, each material that forms the graphite-based composite of the present invention will be described.

### (1) Graphite Powder

The graphite powder that forms the graphite-based composite of the present invention may be a natural graphite powder or a synthetic graphite powder each having a crystal structure that is not an amorphous, but the graphite powder is preferably a highly crystalline powder. On the other hand, an amorphous natural graphite powder or synthetic graphite powder has a high coefficient of thermal expansion and a low thermal conductivity, and therefore cannot be used as a graphite powder that forms the present invention. Preferred examples of a specific graphite powder that forms the present invention include graphite powders having the following structures. Examples thereof include a natural graphite powder or a synthetic graphite powder each having, as a molecular structure, a layered structure in which two-dimensional mesh-like structures are stacked, a diamond powder or a synthetic graphite crystalline powder each having a three-dimensional mesh-like structure, and a synthetic, crystalline nanocarbon extending spirally and cylindrically. Each of the highly crystalline graphite powders can be suitably used for the graphite-based composite of the present invention because each of the highly crystalline graphite powders has a high thermal conductivity and a low coefficient of thermal expansion in the layered direction in the case of a layered crystal, in the three-dimensional direction in the case of a diamond powder, or in the growth direction in the case of a nanocarbon.

More specifically, as the graphite powder that forms the graphite-based composite of the present invention, any of the crystalline graphite powders as given below, which are not amorphous materials, can be used. For example, the following graphite powders can also be used: a synthetic graphite powder obtained by adding tar, pitch, or the like to carbon having a layered structure, firing the resulting mixture at about 3,000°C or higher, and then pulverizing the fired product; a natural layered graphite powder; a natural or human-made diamond powder having a diamond structure; and a nanocarbon aggregate obtained by preliminarily molding and firing ultrafine powder nanocarbon to be aggregated into an easily handleable powder. On the other hand, according to studies conducted by the present inventors, a material obtained by mixing an organic binder such as tar or pitch with a coke powder, molding the resulting mixture, and firing the molded material at 2,000°C to 2,500°C has a high coefficient of thermal expansion and a low thermal conductivity because carbon does not completely form a layered crystal structure, and therefore such a material cannot be used as the graphite powder that forms the present invention. Carbon black, tar, or amorphous carbon obtained by firing an organic resin at a low temperature has a low strength, a low thermal conductivity, and a high coefficient of thermal expansion, and therefore even if such amorphous carbon is utilized, the graphite-based composite to be a target of the present invention having a high strength, a high thermal conductivity, and a low coefficient of thermal expansion cannot be obtained.

The natural graphite powder that forms the graphite-based composite of the present invention and that has a crystal structure is desirably scale-like graphite or spherical graphite each having a layered crystal structure. On the other hand, massive natural graphite not having a layered crystal structure has a low thermal conductivity and does not have a low coefficient of thermal expansion and therefore cannot be used as a material for the graphite-based composite of the present invention.

The graphite powder that forms the present invention and that has a crystal structure, as given above, that is not amorphous preferably has an average particle size of 3 µm to 300 µm. Whether or not a graphite powder composed of a natural graphite powder or a synthetic graphite powder is one having a crystal structure, which can be used as a raw material for the graphite-based composite of the present invention, can be easily checked by X-ray diffraction. Usually, a sharp peak appears at a diffraction angle 20 of 24 to 28°. According to studies conducted by the present inventors, a graphite powder having an average particle diameter of smaller than 3 µm is not preferable because the particles are too fine, which makes molding difficult and, in addition to that, the interface between particles is large, which makes the thermal conductivity of the graphite-based composite of the present invention low. On the other hand, when the average particle size is larger than 300 µm, the graphite powder is not preferable in terms of moldability because molding by pressing or the like is made difficult. According to studies conducted by the present inventors, as for a more preferred range of the average particle size of the graphite powder that forms the present invention, a graphite powder having an average particle size of 5 µm to 250 µm is preferably used, and a graphite powder having an average particle size of 10 µm to 200 µm is more preferably used. Setting the average particle size in the above-described range makes it possible to provide a graphite-based composite having a higher industrial utility value in that: it has excellent properties such as a high strength, a high thermal conductivity, and a low coefficient of thermal expansion, which are the objects of the present invention; and, in addition to this, that it enables simple and stable molding. Note that each of the average particle sizes of the powders to be used in the present invention refers to a particle size at an integrated value of 50% in the particle size distribution determined by a laser diffraction/scattering method, that is, a so-called 50% median size.

### (2) Metal Powder and Ceramic Powder

The metal powder and the ceramic powder that form the graphite-based composite of the present invention are not particularly limited but preferably have an average particle size of 0.5 µm to 200 µm, as will be described later. As the metal powder, any of metal powders of, for example, aluminum (Al), silicon (Si), silver (Ag), titanium (Ti), copper (Cu), iron (Fe), and stainless steel (SUS) having a melting point of about 500°C or higher, can be used. Among them, a metal powder of silicon (Si), titanium (Ti), silver (Ag), copper (Cu), or the like is preferably used. As the ceramic powder, a powder selected from powders of, for example, oxides such as alumina and silica, carbides such as boron carbide (B₄C), silicon carbide (SiC), and titanium carbide (TiC), and nitrides such as silicon nitride and aluminum nitride (AlN), can be appropriately utilized.

As for the particle size of the above-described metal powders and ceramic powders that form the present invention, a metal powder or a ceramic powders having an average particle size of 0.5 to 200 µm is preferable. According to studies conducted by the present inventors, when the average particle size is smaller than 0.5 µm, the powder is too fine, which is likely to cause aggregation, so that there is a risk that the metal powder or the ceramic powder cannot be uniformly mixed with the graphite powder which is to be used together the metal powder or the ceramic powder. On the other hand, a powder having an average particle size of larger than 200 µm is not preferable because when such a powder is used, the particle size is too large, which makes molding difficult, and therefore the powder is inferior in moldability, and in addition to that, it is difficult to obtain a composite having a high strength. According to studies conducted by the present inventors, as for a more preferred range of the particle size of the metal powder or the ceramic powder that forms the present invention, a metal powder or a ceramic powder each having an average particle size of 2 to 150 µm is preferably used, and a metal powder or a ceramic powder each having an average particle size of 3 to 100 µm is more preferably used.

### (3) Silica-Based Inorganic Binder

As the silica-based inorganic binder that forms the graphite-based composite of the present invention, colloidal silica, ethyl silicate, water glass, and silicone resins for example can be used. The silica-based inorganic binder is used for preparing a molded body in such a way that it is externally added to 100 parts by volume (including the voids) of the above-described mixed powder within a range of 0.5 to 5% by volume in terms of SiO₂, wherein the mixed powder is used as a raw material for the molded body and contains the graphite powder and the metal powder and/or the ceramic powder. Desirably, the silica-based inorganic binder is preferably externally added in an amount of about 1% or more and about 5% or less on a volume basis based on 100 parts by volume of the mixed powder. According to studies conducted by the present inventors, the silica-based inorganic binder is necessary for improving moldability of the molded material in preparing the molded body formed of the mixed powder and retaining the shape of the molded body after solidification by heating (firing) of the molded material. In other words, the graphite powder that forms the graphite-based composite of the present invention and that has a crystal structure takes a layered structure or a three-dimensional mesh-like structure as described above, and therefore when molding is performed in the molding step of forming a molded body, the force to make the molded body to return to the original state, so-called springback, is large, so that the addition of the silica-based inorganic binder is necessary in order to retain the shape of the molded body even after the firing. On the other hand, an organic binder can be utilized as an auxiliary material during molding in the case where press molding or the like is performed, but the organic binder disappears in calcination which is performed in obtaining a molded body (preform) and therefore cannot be utilized for retaining the shape of the molded body after the calcination. In contrast, according to the present invention, even though the graphite powder composed of a natural graphite powder or a synthetic graphite powder each having a crystal structure that makes moldability inferior is used, the addition of the silica-based inorganic binder into the material for forming a molded material makes it possible to realize providing an industrially and widely utilizable, extremely useful graphite-based composite having a high strength, a high thermal conductivity, and a low coefficient of thermal expansion which are at a high level that cannot be realized by the conventional techniques, which are the objects of the present invention.

### (4) Composition in Graphite-Based Composite

The graphite-based composite of the present invention is characterized in that it is obtained by forming a composite from a molded body having voids and a molten aluminum metal or the like, wherein the molded body is formed of a material obtained by externally adding a silica-based inorganic binder within a range of 0.5 to 5 parts by volume to 100 parts by volume (including the voids) of a mixed powder containing a highly crystalline graphite powder having any of the above-described crystal structures and a metal powder and/or a ceramic powder. The graphite-based composite of the present invention is characterized in that it has a composition containing the graphite powder within a range of 40 to 80% by volume, the aluminum metal or the like within a range of 13 to 50% by volume, the metal powder and/or the ceramic powder within a range of 6 to 45% by volume in total, provided that the total amount of these materials are 100% by volume, wherein the silica-based inorganic binder is further externally added within a range of 0.5 to 5% by volume in terms of SiO₂.

According to studies conducted by the present inventors, when the graphite powder is less than 40% by volume in the composition of a metal and/or ceramic/graphite-containing aluminum composite, the amount of the graphite powder is too small, and therefore the thermal conductivity of the composite is lowered and a material having a high thermal conductivity, which is an object of the present invention, cannot be obtained. On the other hand, when the amount of the graphite powder is more than 80% by volume, the strength of the composite is lowered. Thus, the graphite-based composite of the present invention needs to contain the graphite powder within a range of 40 to 80% by volume. In addition, according to studies conducted by the present inventors, when the total amount of the metal powder and/or the ceramic powder is less than 6% by volume, the effect of improving the strength, which is specified by a flexural strength of 90 MPa or higher which is one of the objects of the present invention, cannot be obtained in the composite. On the other hand, when the total amount of the metal powder and/or the ceramic powder is more than 45% by volume, the thermal conductivity of the composite may be lowered. From these reasons, the graphite-based composite of the present invention needs to contain the metal powder and/or the ceramic powder within a range of 6 to 45% by volume in total.

### <Method for Producing Graphite-Based Composite of the Present Invention>

Next, a method for producing a graphite-based composite of the present invention will be described. According to the production method of the present invention, the above-described excellent graphite-based composite of the present invention can be simply obtained. The production method of the present invention is characterized in that it includes the following molding step of forming a molded body and composite forming step. In the molding step of forming a molded body, the silica-based inorganic binder is added within a range of 0.5 to 5 parts by volume to 100 parts by volume (including voids) to a mixed powder of raw materials prepared in such a way that the total of 40 to 80% by volume of the graphite powder, 6 to 45% by volume in total of a metal powder and/or a ceramic powder, and 13 to 50% by volume of voids after molding is 100% by volume; a molded material is formed with the resulting mixed material; and the molded material is solidified by heating at a temperature of 100°C to 1,100°C to prepare a molded body having voids to be used for composite formation. The above-described solidification by heating is preferably performed in a nitrogen or inert atmosphere as necessary in order to prevent oxidation of the graphite powder.

In the next composite forming step, the voids of the molded body obtained in the molding step of forming a molded body are impregnated with the molten aluminum metal or the like at a pressure of 20 to 200 MPa or the molten aluminum metal or the like is injected into the voids of the molded body obtained in the molding step of forming a molded body, and thus a composite is formed from the molded body and the aluminum metal or the like. As a result, the graphite-based composite having excellent properties is simply obtained, wherein the graphite-based composite contains the graphite powder within a range of 40 to 80% by volume, the aluminum metal or the like in an amount of 13 to 50% by volume, the metal powder and/or the ceramic powder within a range of 6 to 45% by volume in total, provided that the total amount of these materials is 100% by volume; 0.5 to 5% by volume of silica-based inorganic binder in terms of SiO₂ is externally added to these materials; and the graphite-based composite has a flexural strength of 90 MPa or higher, a thermal conductivity of 240 W/m·K or higher in either the XY direction or the Z direction, and a coefficient of thermal expansion of 6.0 ppm/K or lower in either the XY direction or the Z direction.

Hereinafter, each step of the method for producing a graphite-based composite of the present invention will be described in detail.

### (1) Molding Step of Forming Molded Body (Preform)

As described above, in the production method of the present invention, first, the amount of the graphite powder and the amount of the metal powder and/or the ceramic powder are adjusted each in an appropriate amount so that the finally obtained graphite-based composite will have a composition containing the graphite powder within a range of 40 to80% by volume and the metal powder and/or the ceramic powder within a range of 6 to 45% by volume in total to blend and mix the graphite powder and the metal powder and/or the ceramic powder; and a molded material to be made into a molded body is formed using the resultant material by externally adding the silica-based inorganic binder to the mixed powder material to be a raw material within a range of 0.5 to 5 parts by volume based on 100 parts by volume of the total amount of the mixed powder material to be a raw material and the voids. Next, the resultant molded material is heated at a temperature of 100°C to 1,100°C for solidification to prepare a molded body (preform) which is used for composite formation. The method for forming the molded material before the solidification by heating is not particularly limited, and compression molding methods such as press molding, pressure filter press, rolling roll molding, CIP molding, and a sedimentation method, and various methods such as cast molding with a gypsum mold can be used for example.

The void content of the molded body before forming a composite can be controlled by controlling the molding pressure during compression molding which is performed in the methods as given above. For example, in usual press molding, a molded body having 15 to 50% by volume of voids is obtained. Thus, according to the production method of the present invention, the graphite powder and the metal powder and/or the ceramic powder can be blended in a range of 50 to 85% by volume, which corresponds to the volume excluding the voids, and therefore the production method of the present invention has an advantage that material design is easy to perform. In addition, according to the production method of the present invention, in the molding step of forming a molded body, the proportion of the graphite powder and the metal powder and/or the ceramic powder, which are materials for the molded body, can be easily made suitable so that the final graphite-based composite can have desired high strength, high thermal conductivity, and low coefficient of thermal expansion, which are the objects of the present invention. Furthermore, by controlling the type and amount of the silica-based inorganic binder which is used in the production method of the present invention, and the molding pressure during compression molding, the amount of the voids in the molded body (preform) can be easily made suitable in the next composite forming step, wherein the voids become the aluminum sites in the composite which is obtained by impregnating the molded body with the molten aluminum metal or the like to form a composite in the next composite forming step, which will be described later.

In the production method of the present invention, the molding step of forming a molded body (preform) which is used for forming a composite is characterized in that, as described above, the silica-based inorganic binder is externally added within a range of 0.5 to 5 parts by volume in terms of SiO₂ to 100 parts by volume of the total amount of the mixed powder of the graphite powder and the metal powder and/or the ceramic powder, which is a raw material, and the voids of the mixed powder, and the molded material is formed with the resultant material. It is necessary to use the silica-based inorganic binder as the binder which is used here. Examples of the silica-based inorganic binder include colloidal silica, ethyl silicate, silicone resins, and water glass composed of sodium silicate, and any of these can be suitably used. The addition amount of the silica-based inorganic binder which is used in the production method of the present invention is about 0.5 to about 5 parts by volume in terms of SiO₂ based on 100 parts by volume of the total amount of the mixed powder which is a raw material and the voids of the mixed powder. Desirably, the silica-based inorganic binder is added in an amount of 1.0% or more and 5% or less on a volume basis. According to studies conducted by the present inventors, when the amount of the silica-based inorganic binder is less than 0.5 parts by volume, the effect due to addition of the inorganic binder is not obtained sufficiently. In addition, when the silica-based inorganic binder is added in an amount of more than 5 parts by volume, the proportion of the graphite and the other raw materials to be blended is relatively small, and therefore there is a risk that the thermal conduction is impaired.

According to studies conducted by the present inventors, the addition of the silica-based inorganic binder is necessary for good molding of the molded material, which is performed using the mixed powder material; and furthermore, retaining the shape of the molded body after solidification by heating (firing) of the resulting molded material. The graphite powder having a crystal structure, which forms the graphite-based composite to be obtained by the production method of the present invention, takes a layered or three-dimensional mesh-like structure, and therefore when the molded material is formed using a compression molding method in particular, the force to make the molded material and the molded body to return to the original state, so-called springback, is large. Accordingly, the addition of the silica-based inorganic binder to the material for preparing the molded body specified in the present invention is an important requirement to retain the shape of the molded body in a good condition, and also to retain, in a good condition, the molded material which is obtained in the above-described molding step of forming a molded body, and furthermore to retain, in a good condition, the molded body after solidification by heating of the molded material.

In the method for producing a graphite-based composite of the present invention, an organic binder can also be used together with the inorganic binder when the inorganic binder is added. Here, the addition amount of the organic binder is desirably 5 parts by mass or less. As the organic binder, tar or pitch, and a thermosetting resin such as a phenol resin, and the like can be used for example. The organic binder can be added as an auxiliary material during molding such as press molding but disappears by calcination, and therefore the use of the inorganic binder is necessary in the production method of the present invention in which retaining the shape of the molded body after calcination is an important issue.

In the production method of the present invention, respective materials for producing the molded body, which are described above, are mixed and stirred with a mixer in common use and then subjected to pressure molding as described above with a molding machine for press molding, pressure filter press, rolling roll molding, CIP molding, or the like for example. Although the density of the molded body, and the voids associated with the density are different depending on the molding pressure, press molding, CIP molding, or the like is performed by applying a pressure of, for example, 10 MPa (100 kgf/cm²) to 200 MPa (2,000 kgf/cm²). Specifically, when a press mold with 60 mmϕ for example is used, the load is 28 kN to 560 kN. In this way, a molded material in a good condition, having 13 to 50% by volume of voids, can be produced. As described above, these voids correspond to impregnated sites of the aluminum metal or the like, which will be formed in the next step, and therefore to control the molding pressure is important for obtaining a desired impregnation ratio with the aluminum metal or the like. The molded material molded in the manner as described above is solidified by heating at a temperature of 100 to 1,100°C in the air or, if necessary, in an inert atmosphere such as nitrogen or argon, into the molded body (preform) in a good condition, which will be subjected to high-pressure impregnation with the molten aluminum metal or the like in the next composite forming step.

### (2) Graphite-based Composite Preparation (Composite Forming) Step

In the production method of the present invention, the molded body (preform) having 13 to 50% by volume of voids, prepared in the manner as described above, is impregnated with the molten aluminum metal or the like to fill the voids with the molten aluminum metal or the like, and then the molten aluminum metal or the like is solidified to form a composite, and thus the graphite-based composite of the present invention is obtained. The method for impregnating the voids of the molded body with the molten aluminum metal or the like is not particularly limited, and, for example, squeeze cast, die cast, or a high-pressure impregnation method with a high-pressure press machine can be used. The impregnation pressure within a range of 20 to 200 MPa, preferably within a range of 30 to 200 MPa, is appropriate here according to studies conducted by the present inventors, although it depends on the density and void content of the molded body (preform) prepared in the manner as described above, and the particle sizes of the graphite powder and the metal powder and/or the ceramic powder, which are used for preparing the molded body. An impregnation pressure of lower than 20 MPa is not preferable because the impregnation pressure is low and therefore the impregnation with the aluminum metal or the like may be insufficient. On the other hand, when the impregnation pressure is more than 200 MPa, the impregnation with the aluminum metal or the like is completed, but an impregnation pressure of 200 MPa or lower is enough taking energy to be consumed and the life of a metal mold into consideration.

### Examples

Hereinafter, the present invention will be described specifically based on Examples and Comparative Examples, but the present invention is not limited to these Examples. Note that in Examples and Comparative Examples, "%" is based on the percentage by volume unless otherwise noted, and "parts" are based on volume unless otherwise noted. The percentage by volume is calculated from the mass ratio of a raw material powder, the specific gravity of each material such as graphite, and the void content of the molded body to be formed. Unless otherwise noted, the amount of the silica-based inorganic binder is the percentage by volume of the externally added silica-based inorganic binder when the total amount of the mixed powder and the aluminum metal or the like (with which the voids of the molded body are impregnated), which are the main raw materials and their amounts are specified in the present invention, is assumed to be 100% by volume. The composition and characteristic values of each of the graphite-containing aluminum composites of Examples and Comparative Examples are shown together in Table 1-1 and Table 1-2.

### [Example 1]

In the present example, as the graphite powder, two types of the following synthetic graphite were mixed and used: synthetic graphite CGB-90 (trade name, average particle size 90 µm) and synthetic graphite CGB-8R (trade name, average particle size 8 µm), each manufactured by Nippon Graphite Industries, Co., Ltd. The crystal structures of these synthetic graphite were checked by X-ray diffraction measurement to find that both had a layered graphite crystal structure.

Specifically, as the graphite powder, 30 parts on a mass basis of the synthetic graphite having an average particle size of 8 µm and 70 parts on a mass basis of the synthetic graphite having an average particle size of 90 µm were blended and mixed for use. Then, to 100 parts of the blend of the two types of graphite (specific gravity:2.2) and, as the ceramic powder, 43 parts of a SiC powder (specific gravity: 3.2) having an average particle diameter of 4 µm, an ethyl silicate solution was added as the inorganic binder such that the amount of ethyl silicate externally added corresponded to 1.2% by volume in terms of SiO₂, and the resulting mixture was mixed sufficiently with a mixer. This mixture was placed in a metal mold with 60 mmϕ and press-molded at a load of 80 kgf/cm² and then fired (calcined) in an air atmosphere at 400°C for 1 hour to obtain a molded body (preform) having 22% of voids.

The molded body having voids, obtained above, was heated to 500°C and loaded in a press machine and high-pressure-impregnated with a molten aluminum alloy of AC3A whose temperature was 730°C at a pressure of 50 MPa with a high-pressure press machine to obtain a composite of the present example in which the voids of the molded body were impregnated with the aluminum alloy. As shown in Table 1-1, the composition of the ceramic/graphite-containing aluminum composite obtained in the above-described composite forming step was such that 1.2% of the inorganic binder in terms of SiO₂ was externally added to 100% of the total amount of 60% of graphite, 18% of SiC, and 22% of the aluminum alloy.

The composite of the present example obtained above was a composite having a high strength and a high thermal conductivity, the composite having a flexural strength of 120 MPa, and a thermal conductivity of 390 W/m K in the XY direction, 80 W/m K in the Z direction, and 235 W/m K on the average. The composite of the present example had a coefficient of thermal expansion of 5.5 ppm/K in the XY direction, 13.5 ppm/K in the Z direction, and 9.5 ppm/K on the average. The obtained results are shown together in Table 1-2. From these results, it was found that the composite (material) having the above-described composition is a material having a high strength, a high thermal conductivity, and a low coefficient of thermal expansion and can be suitably utilized, for example, for a power module base and a heat dissipation plate. Particularly, the composite (material) of the present example has a low coefficient of thermal expansion in the XY direction, as described above, and therefore there are possibilities that the composite (material) of the present example can be used as a base for silicon semiconductor devices, a base for silicon carbide semiconductor devices, a base for gallium nitride semiconductor devices, and the like, having a low coefficient of thermal expansion.

The flexural strength of the above-described composite was measured by preparing a specimen of 3 × 4 × 40 mm to conduct a three-point flexural test according to JIS R 1601. The thermal conductivity was measured by preparing a specimen having 10 mmϕ and a thickness of 2 mm to conduct a laser flash method. As for the laser flash method used for the measurement of the thermal conductivity, the measurement was conducted with reference to JIS R 1611, which is the specification on ceramics. The coefficient of thermal expansion was measured with a push-rod thermal dilatometer TMA-60 (trade name, manufactured by SHIMADZU CORPORATION). The measurement was performed at 25°C (room temperature) in all cases. In the other examples, the measurement was performed in the same manner.

### [Examples 2 to 4]

To a graphite powder having the same composition used in Example 1 and obtained by mixing two types of graphite each having a different average particle size, a ceramic powder of any one of the SiC powder (average particle size: 4 µm), an AlN powder (average particle size: 3 µm, specific gravity: 3.3), or an alumina powder (average particle size: 5 µm, specific gravity: 4.0) was added in a desired amount as shown in Table 1-1, and each molded body (preform) having voids was prepared by the same method as in Example 1. The resulting molded bodies (preforms) had 15%, 22%, and 25% of voids respectively, and each of them was in a good condition. Next, the molded bodies having voids, obtained above, were impregnated with a molten aluminum alloy of AC3A, which was the same as used in Example 1, in the composite forming step using a press machine, which was the same step as in Example 1, and thus ceramic/graphite-containing aluminum composites of Examples 2 to 4 were prepared. In Table 1-1, the material compositions of the obtained composites and the results of flexural strength measurement are shown.

For each of the obtained ceramic/graphite-containing aluminum composites, the same evaluation tests as in Example 1 were conducted by the same methods as in Example 1, and the obtained evaluation results are shown together in Table 1-2. Any of the graphite-based composites of Examples 2 to 4 exhibited a high strength as high as a flexural strength of 90 MPa or higher, a coefficient of thermal expansion of 6 ppm/K or lower in the XY direction, and a thermal conductivity of 240 W/m·K or higher in the XY direction, as shown in Table 1-2, demonstrating that each of the graphite-based composites of Examples 2 to 4 was a material exhibiting a high strength, a high thermal conductivity, and a low coefficient of thermal expansion, which are the objects of the present invention.

### [Example 5]

In the present example, F#2 (trade name, average particle size 130 µm) manufactured by Nippon Graphite Industries, Co., Ltd., which is a natural graphite powder having a layered crystal structure, was used as the graphite powder. To 100 parts of this natural graphite powder, 27 parts of a Si powder (specific gravity: 2.3) having an average particle size of 45 µm, as the metal powder, and an ethyl silicate solution, as the inorganic binder, in an amount corresponding to 1.5% in terms of SiO₂ were added to prepare a molded body (preform) having 22% of voids and being in a good condition by the same method as in Example 1. Then, the resulting molded body was impregnated with a molten aluminum alloy using a high-pressure press machine by the same method and material as in Example 1 to obtain a Si metal/graphite-containing aluminum composite having a composition such that 1.5% of the inorganic binder in terms of SiO₂ was externally added to 100% by volume of the total amount of 62% of graphite, 16% of the Si powder, and 22% of the aluminum alloy.

For the Si metal/graphite-containing aluminum composite obtained in the manner as described above, the same evaluation tests as in Example 1 were conducted by the same methods as in Example 1, and the obtained evaluation results are shown in Table 1-2. As shown in Table 1-2, the graphite-based composite of the present example had a high strength as high as a flexural strength of 95 MPa, a thermal conductivity of 394 W/m·K in the XY direction, 70 W/m·K in the Z direction, and an average thermal conductivity of 232 W/m·K. The graphite-based composite of the present example had a coefficient of thermal expansion of 3.6 ppm/K in the XY direction, 16.7 ppm/K in the Z direction, and 10.2 ppm/K on the average. As just described above, the composite of the present example was a Si metal/graphite-containing aluminum composite exhibiting a high strength, a high thermal conductivity, and a low coefficient of thermal expansion. Particularly, the composite of the present example exhibited a low coefficient of thermal expansion of 3.6 ppm/K in the XY direction, demonstrating that it exhibits a satisfactorily low coefficient of thermal expansion.

### [Example 6]

In the present example, a natural graphite powder which was the same as used in Example 5 was used as the graphite powder. To 100 parts of this natural graphite powder, 50 parts of a titanium powder (specific gravity: 4.5) having an average particle size of 55 µm was added as the metal powder to prepare a molded body (preform) having 21% of voids and being in a good condition by the same method as in Example 1. Then, the resulting molded body was impregnated with a molten aluminum alloy using a high-pressure press machine by the same method and material as in Example 1 to obtain a titanium metal/graphite-containing aluminum composite of the present example having a composition such that 1.2% of the inorganic binder in terms of SiO₂ was externally added to 100% of the total amount of 59% of graphite, 20% of titanium, and 21% of the aluminum alloy.

For the titanium metal/graphite-containing aluminum composite obtained in the manner as described above, the same evaluation tests as in Example 1 were conducted by the same methods as in Example 1, and the obtained evaluation results are shown in Table 1-2. As shown in Table 1-2, the composite obtained above had a high strength as high as a flexural strength of 130 MPa, a thermal conductivity of 265 W/m·K in the XY direction, 114 W/m·K in the Z direction, and an average thermal conductivity of 189 W/m·K. The composite obtained above had a coefficient of thermal expansion of 4.6 ppm/K in the XY direction, 16.0 ppm/K in the Z direction, and 10.3 ppm/K on the average. As just described above, the composite of the present example was a titanium metal/graphite-containing aluminum composite exhibiting a high strength, a high thermal conductivity, and a low coefficient of thermal expansion.

### [Example 7]

A mixed material obtained by mixing the same materials as used in Example 1 in the same ratio as in Example 1 was placed in a vacuum pack to suck the air. Thereafter, CIP molding (cold isostatic pressing) was performed at a pressure of 200 kgf/cm² to obtain a molded body (preform) in which the density was uniform and was less directive, the molded body having 19% of voids and being in a good condition. The resulting molded body was high-pressure-impregnated at a presser of 50 MPa with the same molten aluminum alloy as used in Example 1 using the same high-pressure press machine as used in Example 1 to obtain a ceramic/graphite-containing aluminum composite. The composite had a composition such that 1.5% of the inorganic binder in terms of SiO₂ was externally added to 100% of the total amount of 62% of graphite, 19% of SiC, and 19% of the aluminum alloy.

For the ceramic/graphite-containing aluminum composite obtained in the manner as described above, the same evaluation tests as in Example 1 were conducted by the same methods as in Example 1, and the obtained evaluation results are shown in Table 1-2. The composite obtained above had a thermal conductivity of 250 W/m·K in the XY direction and 220 W/m·K in the Z direction, and therefore was a ceramic/graphite/aluminum-containing composite such that the thermal conductivity in the XY direction and the thermal conductivity in the Z direction are close to each other. The reason for this considered to be as follows: the molded body (preform), when produced by CIP molding, was isotropically compression-molded, and therefore graphite, which takes a layered structure, was randomly oriented, and as a result, the direction of the thermal conductance in the resulting composite was also random. The composite obtained above exhibited a high strength as high as a flexural strength of 130 MPa. The composite obtained above had a coefficient of thermal expansion of 5.8 ppm/K in the XY direction, 9.3 ppm/K in the Z direction, and 7.6 ppm/K on the average.

### {Example 8}

In the present example, F#2 (trade name, average particle size 130 µm), which is a natural graphite powder having a layered crystal structure, was used as the graphite powder, as in Example 5. To 100 parts of this natural graphite powder, 30 parts of the Si powder having an average particle size of 45 µm, as the metal powder, and the following silicone resin solution, as the silica-based inorganic binder, in a desired amount were added to prepare a molded body (preform) having voids. The silicone resin solution used above is a 20w% conc. resin solution prepared by dissolving KR-220 (trade name, manufactured by Shin-Etsu Chemical Co., Ltd.) in isopropyl alcohol (IPA), and in the present example, this resin solution was added in an amount corresponding to 2.0% as SiO₂.

In the present example, in preparing the molded body (preform) having voids, press molding was performed at 75 kN (270 kgf/cm²), which was a higher load than in Example 1, and then calcination was performed by the same method as in Example 1 to obtain a molded body (preform) having about 17% of voids and being in a good condition. Then, the resulting molded body was impregnated with a molten aluminum alloy by the same method and material as in Example 1 using a high-pressure press machine to obtain a Si metal/graphite-containing aluminum composite having a composition such that 2.0% of the inorganic binder in terms of SiO₂ was externally added to 100% of the total amount of 65% of graphite, 18% of the Si powder, and 17% of aluminum.

The composite of the present example obtained above was a composite having a high strength and a high thermal conductivity, the composite having a flexural strength of 150 MPa, and a thermal conductivity of 450 W/m K in the XY direction, 130 W/m K in the Z direction, and 290 W/m K on the average. The composite of the present example had a coefficient of thermal expansion of 3.2 ppm/K in the XY direction, 14.4 ppm/K in the Z direction, and 8.8 ppm/K on the average. In the present example, the press pressure in preparing the molded body by press molding was stronger than that in Example 1, and as a result, the effect due to the addition of the silica-based inorganic binder was exhibited more, so that a composite having high graphite powder and Si metal powder volume percentages was obtained without the occurrence of the springback of the molded body.

### [Example 9]

In the present example, to 100 parts of the two types of the synthetic graphite mixed in the same manner as in Example 1, 37 parts of the titanium powder as the metal powder, 40 parts of the SiC powder as the ceramic powder were added; and to the main raw materials, the ethyl silicate solution was externally added as the silica-based inorganic binder so that the addition amount would be 1.2% in terms of SiO₂, and these raw materials were mixed. Then, the mixed raw materials thus prepared were molded and calcined in the same manner as in Example 1 to prepare a molded body (preform) having 20% of voids. The voids of the resulting molded body (preform) were impregnated with an aluminum alloy by the same material and operation as in Example 1 using a high-pressure press.

As a result, The composite of the present example obtained above was a composite having a high strength and a high thermal conductivity, the composite having a flexural strength of 135 MPa, and a thermal conductivity of 380 W/m K in the XY direction, 115 W/m K in the Z direction, and 247 W/m K on the average. The composite of the present example had a coefficient of thermal expansion of 5.5 ppm/K in the XY direction, 14.0 ppm/K in the Z direction, and 9.8 ppm/K on the average. The above-described results demonstrated that addition of the metal powder and the ceramic powder each in a desired amount also gives a useful composite that exhibits a high strength, a high thermal conductivity, and a low coefficient of thermal expansion.

### [Comparative Example 1]

In the present example, the graphite powder having the same composition as the one used in Example 1, in which the two types of synthetic graphite each having a different average particle size were used together, was used as the graphite powder. As shown in Table 1-1, a molded body (preform) was prepared to obtain a graphite-containing aluminum composite for comparison using the molded body in the same manner as in Example 1 except that neither the metal powder nor the ceramic powder was added. Specifically, a graphite material obtained by adding, as the silica-based inorganic binder, the ethyl silicate solution in an amount corresponding to 1.2% in terms of SiO₂ in the same manner as in Example 1, was used to prepare a molded body (preform) by the same operation as in Example 1. As a result, the resulting molded body (preform) was in a good condition but had 12% of voids, and therefore the number of the voids were smaller than that of the molded body (preform) of Example 1. The resulting molded body was impregnated with the same aluminum alloy as used in Example 1 at a pressure of 50 MPa using a high-pressure press machine in the same manner as in Example 1 to obtain a graphite-containing aluminum composite for comparison.

The graphite-containing aluminum composite of Comparative Example 1 obtained in the manner as described above had a composition such that 1.2% of the inorganic binder in terms of SiO₂ was externally added to 100% of the total amount of 88% of graphite and 12% of the aluminum alloy, as shown in Table 1-1. For the graphite-containing aluminum composite obtained in the manner as described above, the same evaluation tests as in Example 1 were conducted by the same methods as in Example 1, and the obtained evaluation results are shown in Table 1-2.

As shown in Table 1-2, the composite obtained above exhibited a high thermal conductivity, the composite having a thermal conductivity of 410 W/m K in the XY direction, 75 W/m K in the Z direction, and 243 W/m K on the average. The composite obtained above exhibited a small value of coefficient of thermal expansion, which was the same as in Example 1, the composite having a coefficient of thermal expansion of 3.6 ppm/K in the XY direction, 15.1 ppm/K in the Z direction, and 9.4 ppm/K on the average. However, the flexural strength was low as low as 25 MPa, and therefore the composite obtained above was not a composite that exhibits a high strength as high as a flexural strength of 90 MPa or higher, which is an object of the present invention. The reason that the strength of the composite of Comparative Example 1 was extremely low as described above is considered to be as follows: neither the metal powder nor the ceramic powder was used as the material for forming the molded body; and the amount of graphite was too high as high as 88%.

### [Comparative Examples 2 to 4]

In Comparative Examples 2 to 4, a graphite powder obtained by mixing desired amounts of two types of synthetic graphite having a layered graphite crystals which were the same as used in Example 1 except that the average particle sizes were different was used as the graphite powder. As shown in Table 1-1, in each of Comparative Examples 2 and 3, the SiC powder (average particle size: 4 µm), which is the ceramic powder, was used in an amount out of the range specified in the present invention, and in Comparative Example 4, the total amount of the metal powder and the ceramic powder was larger than the total amount thereof specified in the present invention. A molded body (preform) was prepared by the same operation as in Example 1 except for those described above. The resulting molded body was impregnated with the same molten aluminum alloy as used in Example 1 at a pressure of 50 MPa using a high-pressure press machine in the same manner as in Example 1, and thus metal or ceramic/graphite-containing aluminum composites of Comparative Examples 2 to 4 were obtained.

For each of the composites of Comparative Examples 2 to 4 obtained in the manner as described above, the same evaluation tests as in Example 1 were conducted by the same methods as in Example 1, and the obtained evaluation results are shown in Table 1-2. As shown in Table 1-2, none of the composites of Comparative Examples 2 to 4 obtained above was a composite that was able to achieve the objects of the present invention by the following reason. First, when the addition amount of the ceramic powder was lower than that specified in the present invention, as in the composite of Comparative Example 2, the strength was improved slightly as compared to the composite of Comparative Example 1 where neither the ceramic powder nor the metal powder was used, but the composite of Comparative Example 2 had a flexural strength of 40Mpa, and therefore was not able to be put into practical use.

On the other hand, in each of the composites of Comparative Examples 3 and 4, the total amount of the metal and/or the ceramic was above the range specified in the present invention as shown in Table 1, and therefore the composites of Comparative Examples 3 and 4 are composites having a composition in which the amount of the graphite powder is below the range specified in the present invention. It was found that each of the composites of Comparative Examples 3 and 4 having such a composition in which the total amount of the metal and/or the ceramic was too large did not achieve a strength of 90 MPa or higher, that is, had a strength that cannot be said to be sufficient, and had a low thermal conductivity, and therefore was not a material that exbibits a high thermal conductivity intended and specified in the present invention.

### [Comparative Example 5]

A composite of the present example was prepared by the same operation as in Example 1 except that: the synthetic graphite powder and the SiC powder which were the same as those used in Example 1 were used as the graphite powder raw material and the ceramic powder raw material; and a raw material composition in which the inorganic binder was not added was adopted. As a result, in the composite obtained in Comparative Example 5, the amount of the aluminum alloy was larger than that in the composite obtained in Example 1. The reason is considered as follows: the inorganic binder was not added, and therefore, the springback occurred to the molded body (preform) when press molding was performed and then firing was performed, which increased the number of voids in the molded body. The composite obtained in Comparative Example 5 had a lower thermal conductivity than that specified in the present invention, a larger coefficient of thermal expansion than that intended in the present invention, and a low flexural strength, which did not achieve a value of higher than 90 MPa as an object of the present invention, and therefore was not a material satisfying the properties which were the objects of the present invention.

**Table 1-1: Preparation conditions and flexural strength of composites of Examples and Comparative Examples**

| | Types of raw materials and composition for composite [% by volume] | | | | | Properties |
|---|---|---|---|---|---|---|
| | Graphite powder | Metal powder | Ceramic powder | Inorganic Binder* | Aluminum alloy | Flexural strength (MPa) |
| Example 1 | 2SyntheticGr:60* | - | Particle size 4µm | Ethyl silicate | 22 | 120 |
| | | | SiC:18 | SiO₂:1.2 | | |
| Example 2 | 2SyntheticGr:67 | - | Particle size 4µm | Ethyl silicate | 25 | 94 |
| | | | SiC:8 | SiO₂:1.2 | | |
| Example 3 | 2SyntheticGr:60 | - | Particle size 3µm | Ethyl silicate | 15 | 120 |
| | | | AlN:25 | SiO₂:1.2 | | |
| Example 4 | 2SyntheticGr:53 | - | Particle size 5µm | Ethyl silicate | 22 | 105 |
| | | | Alumina:25 | SiO₂:1.2 | | |
| Example 5 | NaturalGr:62 | 45µm Si:16 | - | Ethyl silicate | 22 | 95 |
| | | | | SiO₂:1.5 | | |
| Example 6 | NaturalGr:59 | 55µm Ti:20 | - | Ethyl silicate | 21 | 130 |
| | | | | SiO₂:1.2 | | |
| Example 7 | 2SyntheticGr:62 | - | Particle size 4µm | Ethyl silicate | 19 | 130 |
| | | | SiC:19 | SiO₂:1.5 | | |
| Example 8 | NaturalGr:65 | 45µm Si:18 | - | Silicone | 17 | 150 |
| | | | | SiO₂:2.0 | | |
| Example 9 | 2SyntheticGr:55 | 55µm Ti:10 | Particle size 4µm | Ethyl silicate | 20 | 135 |
| | | | SiC:15 | SiO₂:1.2 | | |
| Comparative Example 1 | 2SyntheticGr:88 | Not used | Not used | Ethyl silicate | 12 | 25 |
| | | | | SiO₂:1.2 | | |
| Comparative Example 2 | 2SyntheticGr:87 | - | Particle size 4µm | Ethyl silicate | 9 | 40 |
| | | | SiC:4 | SiO₂:1.2 | | |
| Comparative Example 3 | 2SyntheticGr:31 | - | Particle size 4µm | Ethyl silicate | 14 | 75 |
| | | | SiC:55 | SiO₂:1.2 | | |
| Comparative Example 4 | 2SyntheticGr:27 | Si:20 | Particle size 5µm | Ethyl silicate | 18 | 60 |
| | | | Alumina:35 | SiO₂:1.2 | | |
| Comparative Example 5 | 2SyntheticGr:54 | - | Particle size 4µm | Not used | 30 | 48 |
| | | | SiC:16 | SiO₂:0 | | |

| | | | | | | |
|---|---|---|---|---|---|---|
| * Mass ratio of two types of SyntheticGr (synthetic graphite): 30 parts of syntheticGr (average particle size:8 µm) on a mass basis and 70 parts of syntheticGr (average particle size:90 µm) on a mass basis were used. * Amount of silica-based inorganic binder: % by volume of SiO₂ externally added to main raw materials Ethyl silicate solution or 20 w% IPA solution of silicone was used in an amount corresponding to 2.5 parts in terms of SiO₂ based on 100 parts of raw material mixed powder. | | | | | | |

**Table 1-2: Properties of composites of Examples and Comparative Examples**

| | Outline of composite | Thermal conductivity [W/m·K] | | | Coefficient of thermal expansion [ppm/K] | | | Strength (MPa) |
|---|---|---|---|---|---|---|---|---|
| | | XY direction | Z direction | Average | XY direction | Z direction | Average | |
| Example 1 | 2SyntheticGr | 390 | 80 | 235 | 5.5 | 13.5 | 9.5 | 120 |
| | +SiC | | | | | | | |
| | +inorganic binder | | | | | | | |
| Example 2 | 2SyntheticGr | 400 | 90 | 235 | 5.1 | 14.4 | 9.8 | 94 |
| | +SiC | | | | | | | |
| | +inorganic binder | | | | | | | |
| Example 3 | 2SyntheticGr | 240 | 85 | 172 | 5.0 | 16.0 | 10.5 | 120 |
| | +AlN | | | | | | | |
| | +inorganic binder | | | | | | | |
| Example 4 | 2SyntheticGr | 250 | 55 | 130 | 4.9 | 12.4 | 8.7 | 105 |
| | +alumina | | | | | | | |
| | +inorganic binder | | | | | | | |
| Example 5 | NaturalGr | 394 | 70 | 232 | 3.6 | 16.7 | 10.2 | 95 |
| | +Si metal | | | | | | | |
| | +inorganic binder | | | | | | | |
| Example 6 | NaturalGr | 265 | 114 | 189 | 4.6 | 16.0 | 10.3 | 130 |
| | +Ti metal | | | | | | | |
| | +inorganic binder | | | | | | | |
| Example 7 | 2SyntheticGr | 250 | 220 | 235 | 5.8 | 9.3 | 7.6 | 130 |
| | +SiC | | | | | | | |
| | +inorganic binder | | | | | | | |
| Example 8 | NaturalGr | 450 | 130 | 290 | 3.2 | 14.4 | 8.8 | 150 |
| | +Si metal | | | | | | | |
| | +inorganic binder | | | | | | | |
| Example 9 | 2Gr | 380 | 115 | 247 | 5.5 | 14.0 | 9.8 | 135 |
| | +Ti+SiC | | | | | | | |
| | +inorganic binder | | | | | | | |
| Comparative Example 1 | Free of metal/ceramic | 410 | 75 | 243 | 3.6 | 15.1 | 9.4 | 25 |
| Comparative Example 2 | Blending amount of syntheticGr2 is large | 390 | 80 | 235 | 3.3 | 15.9 | 9.6 | 40 |
| Comparative Example 3 | Blending amount of ceramic is excessive | 110 | 40 | 75 | 6.0 | 12.8 | 9.4 | 75 |
| Comparative Example 4 | Blending amount of metal and ceramic is excessive | 55 | 30 | 43 | 5.8 | 15.3 | 10.6 | 60 |
| Comparative Example 5 | Inorganic binder is not used | 220 | 65 | 143 | 8.6 | 17.8 | 13.2 | 48 |

## Claims

1. A metal and/or ceramic/graphite-containing aluminum composite obtained by forming a composite from a molded body having voids and a molten aluminum metal or a molten aluminum alloy, wherein
the molded body having voids is formed of a mixed powder comprising: a graphite powder comprising a natural graphite powder or a synthetic graphite powder each having a crystal structure that is not amorphous; and a metal powder and/or a ceramic powder,
a silica-based inorganic binder is further added to the mixed powder,
the metal and/or ceramic/graphite-containing aluminum composite comprises the graphite powder within a range of 40 to 80% by volume, the aluminum metal or the aluminum alloy within a range of 13 to 50% by volume, the metal powder and/or the ceramic powder within a range of 6 to 45% by volume in total, provided that the total amount of those materials is 100% by volume, and the silica-based inorganic binder is externally added in an amount of 0.5 to 5% by volume in terms of SiO₂, and
the metal and/or ceramic/graphite-containing aluminum composite has a flexural strength of 90 MPa or higher, a thermal conductivity of 240 W/m·K or higher in either the XY direction or the Z direction, and a coefficient of thermal expansion of 6.0 ppm/K or lower in either the XY direction or the Z direction.

2. The metal and/or ceramic/graphite-containing aluminum composite according to claim 1, wherein the thermal conductivity in the XY direction is 240 W/m·K or higher, the thermal conductivity in the Z direction is 50 W/m·K or higher, the coefficient of thermal expansion in the XY direction is 6 ppm/K or lower, and the coefficient of thermal expansion in the Z direction is 19 ppm/K or lower.

3. The metal and/or ceramic/graphite-containing aluminum composite according to claim 1, wherein the coefficient of thermal expansion in the XY direction is 3 ppm/K or higher and 6 ppm/K or lower.

4. The metal and/or ceramic/graphite-containing aluminum composite according to claim 1 or 2, wherein the silica-based inorganic binder comprises at least any one selected from the group consisting of colloidal silica, ethyl silicate, water glass, and silicone resins.

5. The metal and/or ceramic/graphite-containing aluminum composite according to claim 1 or 2, wherein the graphite powder has an average particle size of 3 µm to 300 µm.

6. The metal and/or ceramic/graphite-containing aluminum composite according to claim 1 or 2, wherein the crystal structure that is not amorphous is any one of crystal structures selected from the group consisting of a layered crystal, a three-dimensional graphite crystal, a diamond crystal, and a fullerene structure.

7. The metal and/or ceramic/graphite-containing aluminum composite according to claim 1 or 2, wherein the metal powder and/or the ceramic powder has an average particle size of 0.5 to 200 µm.

8. The metal and/or ceramic/graphite-containing aluminum composite according to claim 1 or 2, wherein the metal powder is any one selected from the group consisting of a silicon powder, a titanium powder, a silver powder, a copper powder, an iron powder, a stainless steel powder, and an aluminum powder, and the ceramic powder is any one selected from the group consisting of an alumina powder, a silicon nitride powder, a silicon carbide powder, and aluminum nitride powder.

9. A method for producing a metal and/or ceramic/graphite-containing aluminum composite, the method comprising:
a molding step of forming a molded body by adding a silica-based inorganic binder within a range of 0.5 to 5 parts by volume in terms of SiO₂ to 100 parts by volume of a mixed powder of raw materials prepared in such a way that the total of 40 to 80% by volume of a graphite powder comprising a natural graphite powder or a synthetic graphite powder each having a crystal structure that is not amorphous, 6 to 45% by volume in total of a metal powder and/or a ceramic powder, and 13 to 50% by volume of voids in the molded body after molding is 100% by volume, forming a molded material with the resulting material, and solidifying the molded material by heating at a temperature of 100°C to 1,100°C to prepare the molded body having voids to be used for composite formation; and
a composite forming step of impregnating the voids of the molded body with a molten aluminum metal or a molten aluminum alloy at a pressure of 20 to 200 MPa or injecting a molten aluminum metal or a molten aluminum alloy into the voids of the molded body at a pressure of 20 to 200 MPa, thereby forming a composite, wherein
a composite having a flexural strength of 90 MPa or higher, a thermal conductivity of 240 W/m·K or higher in either the XY direction or the Z direction, a coefficient of thermal expansion of 6.0 ppm/K or lower in ether of the XY direction or the Z direction is produced.

10. The method for producing a metal and/or ceramic/graphite-containing aluminum composite according to claim 9, wherein the silica-based inorganic binder comprises at least any one selected from the group consisting of colloidal silica, ethyl silicate, water glass, and silicone resins.

11. The method for producing a metal and/or ceramic/graphite-containing aluminum composite according to claim 9 or 10, wherein the method to be performed in the molding step of forming a molded body is at least any one selected from the group consisting of press molding, pressure filter press, rolling roll molding, CIP molding, a sedimentation method, and cast molding.
